# EUROPEAN PATENT SPECIFICATION

(11) **EP 0 516 423 B1**
(45) Date of publication and mention of the grant of the patent: **01.05.1996**
(21) Application number: 92304852.4
(22) Date of filing: 28.05.1992
(51) Int. Cl.: H03F 3/45

(54) **Composite differential amplifier**
Mehrstufiger Differenzverstärker
Amplificateur différentiel composé

(30) Priority: 29.05.1991 JP 125752/91
(43) Date of publication of application: 02.12.1992
(73) Proprietor: NEC CORPORATION, Tokyo (JP)
(72) Inventor: Nishijima, Kazunori, Tokyo 108-01 (JP)
(74) Representative: Abnett, Richard Charles

(56) References cited:
- EP-A- 0 250 763
- EP-A- 0 286 347
- US-A- 3 786 362
- US-A- 4 701 719
- US-A- 4 904 953

## Description

The invention relates to a composite differential amplifier and more particularly to a composite differential amplifier which enables the DC component of the output voltage of the differential amplifier to be constant.

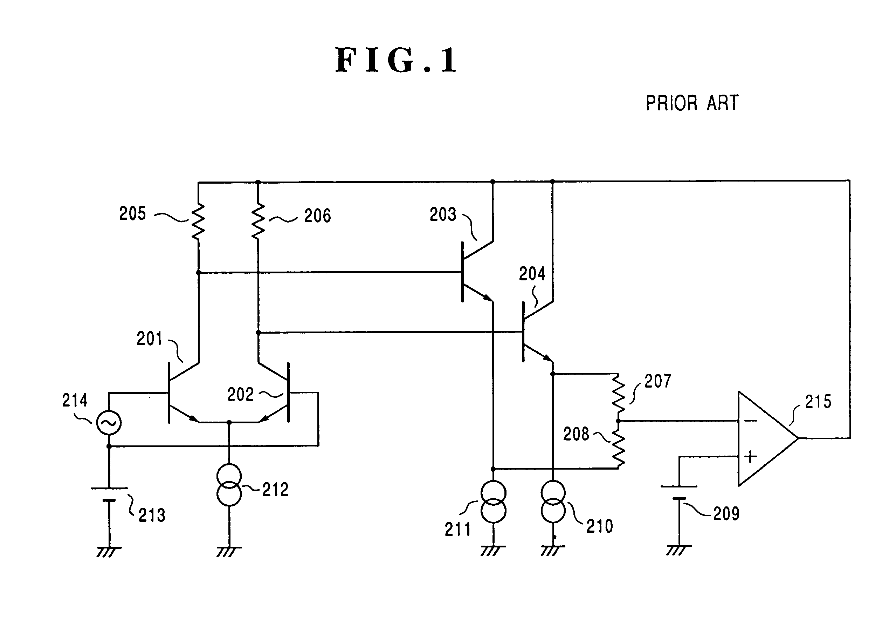

A known composite differential amplifier, as shown in FIG. 1, comprises a differential amplifier, an emitter-follower, resistances 207 and 208 and an operational amplifier 215. The differential amplifier comprises an input signal source 214, transistors 201 and 202, resistances 205 and 206 and a constant current source 212. The emitter follower comprises transistors 203 and 204 and constant current sources 210 and 211.

The operation of the above mentioned composite differential amplifier will hereinafter fully be described in detail with reference to FIG.1 of the accompanying drawings.

Referring to FIG. 1, a signal vᵢ generated by the input signal source 214 is amplified by the differential amplifier. The amplified signals from the transistors 201 and 202 respectively are fed to the base of the transistors 203 and 204 of the emitter-follower. Each signal is further amplified by the transistors 203 and 204 and is delivered from the emitter thereof. Thus, the emitter output voltage Vₒ of transistor 203 is given by${\text{V}}_{\text{O}} {\text{= V}}_{\text{OP}} {\text{- R}}_{\text{L}} {\text{I}}_{\text{O}} {\text{- Av}}_{\text{i}} {\text{- V}}_{\text{BE}}$ where A is the gain of the differential amplifier, 2I_{O} is the current value of the constant current source 212, R_{L} is the resistance value of the resistance 205, V_{OP} is the output voltage of the operational amplifier 215, V_{BE} is the voltage between base and emitter of the transistor 203.

While the output voltage V_{O}' of the emitter of the transistor 204 is also given by${\text{V}}_{\text{O}} {\text{' = V}}_{\text{OP}} {\text{- R}}_{\text{L}} {\text{I}}_{\text{O}} {\text{+ Av}}_{\text{i}} {\text{- V}}_{\text{BE}}$ where A is the gain of the differential amplifier, 2I_{O} is the current value of the constant current source 212, R_{L} is the resistance value of the resistance 206, V_{OP} is the output voltage of the operational amplifier 215 and V_{BE} is the voltage between base and emitter of the transistor 204.

Since the resistance value of the resistance 207 is equal to the resistance value of the resistance 208, the inverting input voltage Vᵢ of the operational amplifier 215 is the middle-point-voltage between the emitter output voltage V_{O} of the transistor 203 and the emitter output voltage V_{O}' of the transistor 204. Then, the inverting input voltage Vᵢ is given by${\text{V}}_{\text{i}} \text{=} \frac{{\text{V}}_{\text{O +}} {\text{V}}_{\text{O}} \text{'}}{\text{2}} {\text{= V}}_{\text{OP}} {\text{- R}}_{\text{L}} {\text{I}}_{\text{O}} {\text{-V}}_{\text{BE}}$

It may therefore be understood from the equation (3) that the inverting input voltage Vᵢ is the DC component of the output voltage which is delivered from the differential amplifier through the emitter-follower. Then, the output voltage V_{OP} of the operational amplifier is given by${\text{A}}_{\text{OP}} {\text{(V}}_{\text{C}} {\text{- V}}_{\text{i}} {\text{) = V}}_{\text{OP}}$ where A_{OP} is the open-gain of the operational amplifier 215, V_{C} is the external control voltage of the operational amplifier 215 from the reference source 209, and Vᵢ is the inverting input voltage of the operational amplifier 215.

The following equation (5) is obtained by substituting the above equation (3) in the above equation (4).${\text{A}}_{\text{OP}} {\text{(V}}_{\text{C}} {\text{- V}}_{\text{i}} {\text{) = V}}_{\text{i}} {\text{+ R}}_{\text{L}} {\text{I}}_{\text{O}} {\text{+ V}}_{\text{BE}}$ Then, the output DC voltage from the differential amplifier is given by${\text{V}}_{\text{i}} \text{=} \frac{{\text{A}}_{\text{OP}} {\text{V}}_{\text{C}} {\text{- R}}_{\text{L}} {\text{I}}_{\text{O}} {\text{- V}}_{\text{BE}}}{{\text{1 + A}}_{\text{OP}}} \text{=} \frac{\text{A}}{{\text{1 + A}}_{\text{OP}}} {\text{·V}}_{\text{C}} \text{-} \frac{{\text{R}}_{\text{L}} {\text{I}}_{\text{O}} {\text{+ V}}_{\text{BE}}}{{\text{1 + A}}_{\text{OP}}}$

Assuming that the open-gain A_{OP} of the operational amplifier 215 is considerably large, the following equation is obtained. When the gain A_{OP} of the operational amplifier is considerably large, the equation (6) is made to the following equation (7) :${\text{V}}_{\text{i}} {\text{≃ V}}_{\text{C}}$

Consequently, the D_{C} component of the output voltage of the differential amplifier is nearly equal to the external control voltage V_{C} from reference source 209 with independence from values of the resistance R_{L}, the current I_{O} and the base-emitter voltage V_{BE}. It therefore may be assumed that the external control voltage V_{C} may be regulated to be constant by the regulators so as to obtain a constant output DC voltage of the differential amplifier.

In the known composite differential amplifier, the output of the operational amplifier 215 serves as a power supply of the differential amplifier. Thus, a high output DC voltage V_{DC} of the differential amplifier may be set with a higher output voltage V_{OP} of the operational amplifier, whereby the source voltage of the operational amplifier is needed to be much higher than the output voltage V_{OP} of the operational amplifier. Further, all circuit currents of the composite differential amplifier are supplied with only the output of the operational amplifier to substantially increase the power consumption of the operational amplifier with a higher external control voltage of the operation amplifier, whereby it is impossible to lower the operational amplifier voltage.

European Patent Application EP-A-0 286 347 describes a differential amplifier circuit which includes a differential amplifier pair, the two outputs of which are connected to two operational amplifiers. The signals from these operational amplifiers are applied to the two ends of two series-connected resistors, and the average signal from the centre-point of the resistors is used as a feedback signal to control two current source circuits, the outputs of which are connected to the two outputs of the differential amplifier.

European Patent Application EP-A-0 250 763 and United States Patent US-A-4 701 719 each describe a differential amplification circuit in which an emitter-follower is connected to the output of a differential amplifier pair. United States Patent US-A-3 786 362 shows the use of common mode signal feedback in a balanced output operational amplifier.

The present invention is defined in claim 1 below, to which reference should now be made. Advantageous features are set forth in the appendant claims.

In accordance with this invention, the differential amplifier pair is connected through an emitter-follower to an operational amplifier which also receives a reference voltage. An average signal from the emitter-follower is applied to one input of the operational amplifier, the output of which is applied to control a variable current source, the output of which is connected to the input of the emitter-follower, or more accurately, to the junction between the output of the differential amplifier pair and the input of the emitter-follower.

By the use of the invention the DC component of the output from the emitter-follower tends towards the reference voltage, and thus the DC component of the output of the operational amplifier approaches the reference voltage.

A preferred embodiment of a composite differential amplifier according to the present invention will hereinafter be described in detail with reference to the accompanying drawings, in which:-
FIG. 1 (described above) is a circuit diagram of a known composite differential amplifier;
FIG. 2 is a circuit diagram of one embodiment of a composite differential amplifier according to the invention; and
FIG. 3 is a circuit diagram of a further more concrete embodiment of FIG. 2 of a composite differential amplifier according to the invention, in which one example of the operational amplifier is shown in detail.

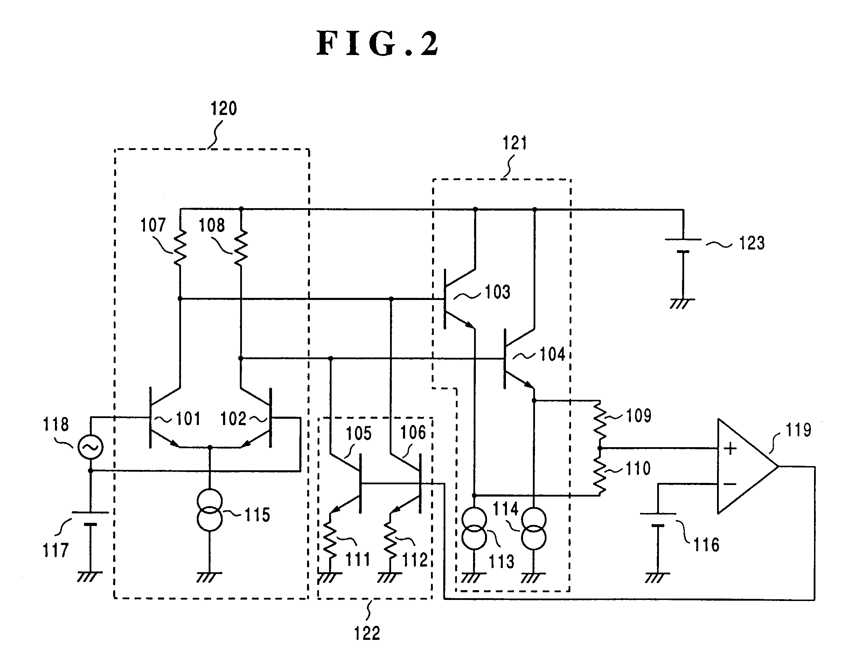

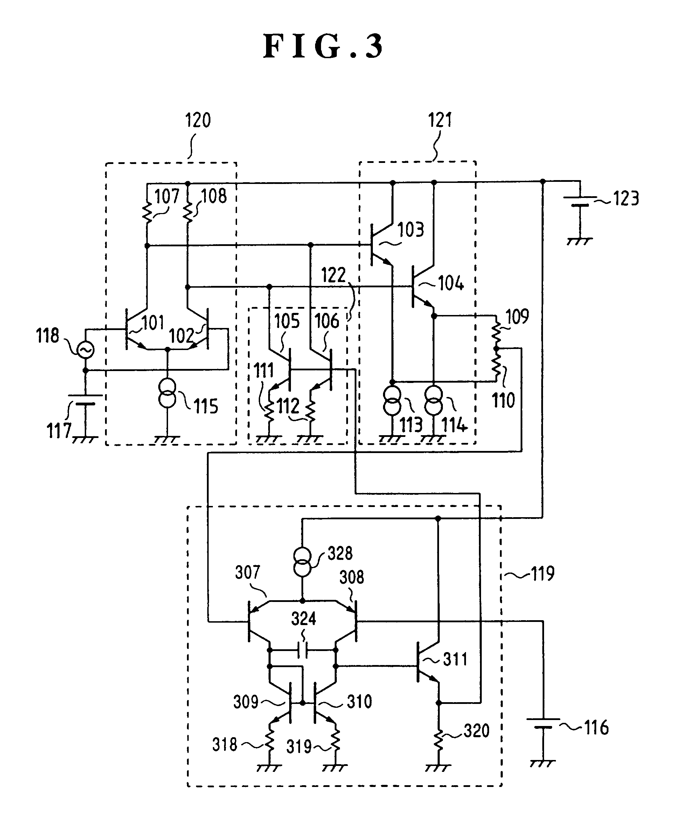

In FIGS. 2 and 3, a composite differential amplifier comprises a differential amplifier 120, an emitter-follower 121, a variable current source 122, an operational amplifier 119, resistances 109 and 110 and a power supply voltage 123. The differential amplifier 120 further comprises an input signal source 118, transistors 101 and 102, resistances 107 and 108, a constant current source 115 and an input bias voltage source 117. The transistors 101 and 102 are connected at their collectors to a DC power supply 123 through the resistors 107 and 108 respectively. The transistors 101 and 102 are grounded at their emitters through the constant current source 115. The transistors 101 and 102 are connected at their bases to opposite sides of the input signal source 118 respectively. The input signal source 118 is grounded through an input bias voltage source 117. As shown, the input signal source has an alternating component.

The emitter-follower 121 comprises transistors 103 and 104, and constant current sources 113 and 114. The transistors 103 and 104 are connected at their collectors to the DC power supply 123. The transistors 103 and 104 are also connected at their bases to the collectors of the transistors 101 and 102 in the differential amplifier 120. Namely, an input of the emitter-follower 121 is connected to an output of the differential amplifier 120. The transistors 103 and 104 are grounded at their emitters through constant current sources 113 and 114. The emitters of the transistors 103 and 104 are connected to opposite ends of series-connected resistors 109 and 110 respectively. The resistors 109 and 110 have the same resistance value. The resistances 109 and 110 may serve to provide the operational amplifier 119 with a middle-point-voltage of the differential output voltage of the emitter-follower 121.

The variable current source 122 comprises transistors 105 and 106, and resistors 111 and 112. The transistors 105 and 106 are connected at their collectors to the collectors of the transistors 101 and 102 in the differential amplifier 120, and thus the outputs of the differential amplifier 120. The transistors 105 and 106 are grounded at their emitters through the resistors 111 and 112 respectively.

The differential amplifier 120 receives an input signal from the input signal source 118 for subsequent amplification of the received signal. The amplified signal from the differential amplifier 120 is transmitted to the emitter-follower 121. The emitter-follower 121 receives the output signal from the differential amplifier 120 for subsequent amplification of the received signal. The emitter-follower 121 outputs signals through the emitters of the transistors 103 and 104. As described above, the output of the emitter-follower 121 is connected to the opposite ends of the series-connected resistors 109 and 110, so that a differential output is obtained from the emitter-follower 121. Respective outputs from the transistors 103 and 104 in the emitter-follower 121 are added to each other through the series-connected resistors 109 and 110, thereby any alternating-current component of the output signal is eliminated and thus only the direct-current component of the output signal remains. Namely, the output signal from the middle point between the resistors 109 and 110 contains the direct-current component.

The output signal from the emitter-follower 121 is transmitted to the operational amplifier 119. The operational amplifier 119 compares the direct-current component of the output signal with the reference voltage. When the direct-current (DC) component of the output signal is higher than the reference voltage, the output from the operational amplifier 119 rises. The output from the operational amplifier 119 is transmitted to the variable current source 122. The variable current source 122 receives the increased output from the operational amplifier 119. The variable current source 122 lowers the output from the differential amplifier 120. In this way the direct-current component of the output from the emitter-follower approaches the reference voltage.

The operation of the circuit is as follows. The input signal voltage vᵢ from the input signal source 118 is amplified by the differential amplifier 120 and outputted from the emitter of each of the transistors 103 and 104 through the emitter-follower 121.

The emitter output voltage Vₒ" of the transistor 103 is given by${\text{V}}_{\text{O}} {\text{" = V}}_{\text{CC}} {\text{- R}}_{\text{L}} {\text{'(I}}_{\text{O}} {\text{' + I}}_{\text{CX}} {\text{)- A'v}}_{\text{i}} {\text{' - V}}_{\text{BE}} \text{'}$ where A' is the gain of the differential amplifier, 2I_{O}' is the current of the constant current source 115, R_{L}' is the resistance value of the resistances 107 and 108, V_{OP}' is the output voltage of the operational amplifier 119, V_{BE} is the voltage between base and emitter of the transistor 103, V_{CC} is the voltage of the power supply 123 and I_{CX} is the current of the variable current source 122, or the collector current of the transistor 105.

And the emitter output voltage V_{O}"' of the transistor 104 is given by${\text{V}}_{\text{O}} {\text{"' = V}}_{\text{CC}} {\text{- R}}_{\text{L}} {\text{'(I}}_{\text{O}} {\text{' + I}}_{\text{CX}} {\text{) + A'v}}_{\text{i}} {\text{' - V}}_{\text{BE}} \text{'}$ where A' is the gain of the differential amplifier, 2I_{O}' is the current of the constant current source 115, R_{L}' is the resistance value of the resistance 108, V_{'OP} is the output voltage of the operational amplifier 119, V_{BE} is the voltage between base and emitter of the transistor 104, V_{CC} is the voltage of the power supply 123, I_{CX} is the current of the variable current source 122, or the collector current of the transistor 105.

Accordingly, the input voltage Vᵢ' of the non-inverting Accordingly, the input voltage Vᵢ' of the non-inverting input of the operational amplifier 119 is a middle-point-voltage between the emitter output voltage V_{O}" of the transistor 103 and the emitter output voltage V_{O}"' of the transistor 104 in which the values of resistances 109 and 110 are equal to each other. Thus, the input voltage Vᵢ' of the non-inverting input of the operational amplifier is given by${\text{V}}_{\text{i}} \text{' =} \frac{{\text{V}}_{\text{O}} {\text{'' + V}}_{\text{O}} \text{'''}}{\text{2}} {\text{= V}}_{\text{CC}} {\text{- R}}_{\text{L}} {\text{'(I}}_{\text{O}} {\text{' + I}}_{\text{CX}} {\text{) - V}}_{\text{BE}} \text{'}$ Namely, the non-inverting input voltage Vᵢ' is the output DC voltage of the differential amplifier 120 which has been delivered through the emitter-follower 121.

Further, the output voltage V_{OP}' of the operational amplifier 119 is given by${\text{A}}_{\text{OP}} {\text{'(V}}_{\text{i}} {\text{'- V}}_{\text{C}} {\text{') = V}}_{\text{OP}} \text{'}$ where A_{OP}' is the open-gain of the operational amplifier 119, Vᵢ' is the non-inverting input voltage of the operational amplifier 119, V_{C}' is the external control voltage of the operational amplifier 119 from the source 116.

The collector current I_{CX} of the transistors 105 and 106 is given by${\text{I}}_{\text{CX}} \text{=} \frac{{\text{V}}_{\text{OP}} {\text{' - V}}_{\text{BE}} \text{''}}{{\text{R}}_{\text{E}}}$

The equation (11) is substituted to the following equation (12) whereby the collector current I_{CX} is replaced with${\text{I}}_{\text{CX}} \text{=} \frac{{\text{A}}_{\text{OP}} {\text{'(V}}_{\text{i}} {\text{' - V}}_{\text{C}} {\text{') - V}}_{\text{BE}} \text{''}}{{\text{R}}_{\text{E}}}$

And further, the equation (13) is substituted to the equation (10) whereby the non-inverting input voltage Vᵢ' is given by

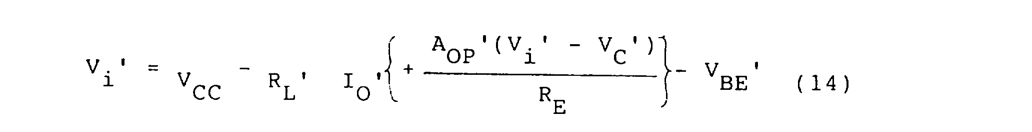

The equation (14) is replaced with the following equation (15) to obtain the non-inverting output voltage Vᵢ' which is given by${\text{V}}_{\text{i}} \text{'=} \frac{{\text{V}}_{\text{CC -}} {\text{R}}_{\text{L}} {\text{'I}}_{\text{O}} \text{' +} \frac{{\text{R}}_{\text{L}} \text{'}}{{\text{R}}_{\text{E}}} {\text{}}^{\text{.}} {\text{A}}_{\text{OP}} {\text{' . V}}_{\text{C}} {\text{' - V}}_{\text{BE}} \text{'}}{\text{( 1 +} \frac{{\text{R}}_{\text{L}} \text{'}}{{\text{R}}_{\text{E}}} {\text{. A}}_{\text{OP}} \text{)}} \text{=} \frac{\frac{{\text{V}}_{\text{CC}} {\text{- R}}_{\text{L}} {\text{'I}}_{\text{O}} {\text{' - V}}_{\text{BE}} \text{'}}{{\text{A}}_{\text{OP}} \text{'}} \text{+} \frac{{\text{R}}_{\text{L}} \text{'}}{{\text{R}}_{\text{E}}} {\text{. V}}_{\text{C}} \text{'}}{\frac{\text{1}}{{\text{A}}_{\text{OP}} \text{'}} \text{+} \frac{{\text{R}}_{\text{L}} \text{'}}{{\text{R}}_{\text{E}}}}$

Assuming that the gain A_{OP}' of the operational amplifier 117 is considerably large, the equation (15) may be replaced with${\text{V}}_{\text{i}} {\text{' ≃ V}}_{\text{c}} \text{'}$

It is of course understood that the output DC voltage of the differential amplifier is nearly equal to the external control voltage V_{c}'.

As is clear from the set forth description, the output of the operational amplifier 119 is connected to the resistance side of the differential amplifier 120 through the variable current source 122 so that when the high output DC voltage of the differential amplifier is set, it is unnecessary to set the output voltage V_{OP} of the operational amplifier high. The operational amplifier 119 may also be operated by the power supply voltage 123 of the differential amplifier. Circuit currents of the differential amplifier are supplied with only the power supply 123 so that the output current of the operational amplifier 119 and power consumption thereof may not be increased. Further, a high voltage for the operational amplifier is unnecessary. These allows lowering conveniently all power voltage of the circuit including the operational amplifier.

The above advantages of the invention will hereinafter concretely be described, as compared with the prior arts. In the conventional differential amplifier of FIG.1, it is assumed that the resistance value of the resistances 205 and 206 are 5 kΩ, the current values of the constant current sources 210, 211 and 212 are 400 µ A, the voltage between base and emitter of each of the transistors 203 and 204 is 0.7 V and the current consumption of the operational amplifier is 1 mA. When the external control voltage V_{C} is 2.8 V, the output DC voltage V_{DC} of the differential amplifier which has been delivered through the emitter-follower may be kept at 2.8 V. In this case, the output voltage V_{OP} of the operational amplifier is 4.5 V. Thus, the supply voltage only of the operational amplifier needs to be at least 8 V. The output current of the operational amplifier is the sum of the current of each of the differential amplifier, the emitter-follower and the operational amplifier. Then, the output current of the operational amplifier is given by$\text{400(µA) X 3 + 1 (mA) = 2.2 (mA)}$

Consequently, the whole power consumption of the circuit is given by$\text{2.2(mA) X 8 (V) = 17.6 (mW)}$

On the other hand, in the embodiment of the composite differential amplifier of FIG.2, it is assumed that the voltage of the power supply 123 is 5 V, the resistance value of each of the resistances 107 and 108 is 5 kΩ, the current of each of the constant current sources 113, 114 and 115 is 400 µA, the current of the variable current source is 100 µA, the voltage between base and emitter of each of the transistors 105 and 106 is 0.7 V and the resistance values of the resistances 111 and 112 are 3 kΩ. When the external control voltage V_{C}' is 2.8 V, the output DC voltage of the differential amplifier which has been delivered through the emitter-follower may be kept at 2.8 V. In this case, the output voltage of the operational amplifier is 1 V and the supply voltage of only the operational amplifier may therefore be set at 5 V. Then, the current drawn by the circuit including the operational amplifier is given by$\text{400 (µA) X 3 + 200 (µA) + 1 (mA) = 2.4 (mA)}$ and the power consumption thereof is also given by$\text{2.4 (mA) X 5 = 12.0 (mW).}$

Consequently, by comparing the invention with the prior art, the embodiment of the composite differential amplifier according to the invention allows reduction of power consumption up to 5.0 (mW).

The embodiment of FIG. 3 is the same as the embodiment of FIG. 2, except that the operational amplifier 119 of FIG. 2 is shown in more detail in FIG. 3. The structure of the operational amplifier 330 is self-evident to those skilled in the art from the figure itself and a detailed verbal description is accordingly not necessary.

It will however be seen from FIG. 3 that the operational amplifier 119 comprises transistors 307 and 308, a constant current source 328, a capacitor 324, transistors 309 and 310, resistors 318 and 319, a transistor 311, and a resistor 320. The transistors 307 and 308 are connected at their emitters to the DC power supply 123 through the constant current source 328. The transistor 307 is connected at its base to the middle point between the resistors 109 and 110. The transistor 308 is connected at its base to the DC power supply 116. The transistor 307 and 308 are coupled to each other at their collectors through the capacitor 324. The transistors 309 and 310 are connected at their collectors to the collectors of the transistors 307 and 308 respectively. The bases of the transistors 309 and 310 are directly connected to each other. The transistor 309 only has a short circuit between its collector and base. The emitters of the transistors 309 and 310 are grounded through resistors 318 and 319 respectively. The transistor 311 is connected at its collector to the DC power supply 123. The transistor 311 is connected at its base to the collectors of the transistors 308 and 310. The transistor 311 is connected at its emitter to the bases of the transistors 105 and 106 in the variable current source 122. Thus, the output of the operational amplifier 119 is connected to the bases of the transistors 105 and 106 in the variable current source 122. The emitter of the transistor 311 is also grounded through a resistor 320.

Whereas alterations and modifications of the present invention will no doubt be apparent to a person of ordinary skilled in the art, it is to be understood that the embodiments shown and described by way of illustration are by no means intended to be considered limitation. Accordingly, it is intended that all alterations of the invention which fall in the scope of the claims are covered.

## Claims

1. A composite differential amplifier, comprising a power source (123) for supplying power to the circuit, a differential amplifier (120) for amplifying a voltage signal inputted from an input signal source, an emitter-follower (121) connected to the output of the differential amplifier (120) for amplifying the voltage signal, an operational amplifier (119) connected to the output of the emitter-follower (121) and to a reference voltage source (116) for amplifying the DC voltage outputted from the emitter-follower, and a variable current source (122) having a control input connected to the output of the operational amplifier (119) and an output connected to the input of the emitter-follower (121) for controlling the voltage at the input of the emitter-follower (121) in response to the output of the operational amplifier such that the DC component of the output from the emitter-follower tends towards the reference voltage from the reference voltage source, whereby the DC component of the output of the operational amplifier approaches the reference voltage.

2. A composite differential amplifier as claimed in claim 1, in which the emitter-follower (121) comprises first means connected to a first side of the output of the differential amplifier (120) for amplifying the voltage signal from the first side, and second means connected to a second side of the output of the differential amplifier (120) for amplifying the voltage signal from the second side.

3. A composite differential amplifier as claimed in claim 2, in which the emitter-follower (121) further comprises a plurality of resistances (109,110) for providing the operational amplifier (119) with a middle-point-voltage between the DC voltage outputted from the first means of the emitter-follower and the DC voltage outputted from the second means of the emitter-follower.

4. A composite differential amplifier as claimed in claim 2 or 3, in which the first means of the emitter-follower (121) comprises a transistor (103) the emitter of which is connected to the input of the operational amplifier, the collector is connected to the power supply (123), and the base is connected to the first side of the output of the differential amplifier (120), and a constant current source for providing a constant base current of the transistor (103).

5. A composite differential amplifier as claimed in claim 2, 3 or 4, in which that the second means of the emitter-follower (121) comprises a transistor (104) the emitter of which is connected to the input of the operational amplifier (119), the collector is connected to the power supply (123) and the base is connected to the second side of the output of the differential amplifier (120), and a constant current source for providing a constant base current of the transistor (104).

6. A composite differential amplifier as claimed in any of claims 1 to 5, in which in the operational amplifier (119), an inverting input terminal is connected to an external control power supply (116), a non-inverting input terminal is connected to the emitter side of each of the transistors (103,104) of the emitter-follower (121) through the resistances (109,110) of the emitter-follower, and an output terminal is connected to an input of the variable current source (122).

7. A composite differential amplifier as claimed in any of claims 1 to 6, in which the variable current source (122) comprises first means connected to the output of the operational amplifier (119) and connected to the first side of the output of the differential amplifier (120) for controlling the voltage of the first side of the output of the differential amplifier (120) in response to the output of the operational amplifier (119), and second means connected to the output of the operational amplifier (119) and connected to the second side of the output of the differential amplifier (120) for controlling the voltage of the second side of the output of the differential amplifier (120) in response to the output of the operational amplifier (119).

8. A composite differential amplifier as claimed in claim 7, in which the first means of the variable current source (122) comprises a transistor (106) the emitter of which is connected to ground through a resistance (112), the collector is connected to the first side of the output of the differential amplifier (120), and the base is connected to the output of the operational amplifier (119).

9. A composite differential amplifier as claimed in claim 7 or 8, in which the second means of the variable current source (122) comprises a transistor (105) the emitter of which is connected to ground through a resistance (111), the collector is connected to the second side of the output of the differential amplifier (120), and the base is connected to the output of the operational amplifier (119).

## Patentansprüche

1. Mehrstufiger Differenzverstärker mit einer Stromversorgung (123) zum Versorgen der Schaltung mit Strom, einem Differenzverstärker (120) zum Verstärken eines von einer Eingangssignalquelle eingegebenen Spannungssignals, einem Emitterfolger (121), der mit dem Ausgang des Differenzverstärkers (120) verbunden ist, zum Verstärken des Spannungssignals, einem Operationsverstärker (119), der mit dem Ausgang des Emitterfolgers (121) und einer Referenzspannungsquelle (116) verbunden ist, zum Verstärken der Gleichspannung, die von dem Emitterfolger ausgegeben wird, und einer regelbaren Stromquelle (122) mit einem Steuereingang, der mit dem Ausgang des Operationsverstärkers (119) verbunden ist, und einem Ausgang, der mit dem Eingang des Emitterfolgers (121) verbunden ist, zum Steuern der Spannung an dem Eingang des Emitterfolgers (121) in Abhängigkeit von dem Ausgangssignal des Operationsverstärkers, so daß die Gleichstromkomponente des Ausgangssignals von dem Emitterfolger zu der Referenzspannung von der Referenzspannungsquelle tendiert, wodurch sich die Gleichstromkomponente des Ausgangs des Operationsverstärkers der Referenzspannung annähert.

2. Mehrstufiger Differenzverstärker nach Anspruch 1, wobei der Emitterfolger (121) eine erste Einrichtung aufweist, die mit einer ersten Seite des Ausgangs des Differenzverstärkers (120) verbunden ist, um das Spannungssignal von dieser einen Seite zu verstärken, und eine zweite Einrichtung, die mit einer zweiten Seite des Ausgangs des Differenzverstärkers (120) verbunden ist, um das Spannungssignal von dieser zweiten Seite zu verstärken.

3. Mehrstufiger Differenzverstärker nach Anspruch 2, wobei der Emitterfolger (121) außerdem eine Vielzahl von Widerständen (109, 110) zum Versorgen des Operationsverstärkers (119) mit einer Mittelpunktspannung zwischen der Gleichspannung, die von der ersten Einrichtung des Emitterfolgers ausgegeben wird, und der Gleichspannung, die von der zweiten Einrichtung des Emitterfolgers ausgegeben wird, aufweist.

4. Mehrstufiger Differenzverstärker nach Anspruch 2 oder 3, wobei die erste Einrichtung des Emitterfolgers (121) einen Transistor (103), dessen Emitter mit dem Eingang des Operationsverstärkers, dessen Kollektor mit der Stromversorgung (123) und dessen Basis mit der ersten Seite des Ausgangs des Differenzverstärkers (120) verbunden ist, sowie eine Konstantstromquelle zum Liefern eines konstanten Basisstroms für den Transistor (103) aufweist.

5. Mehrstufiger Differenzverstärker nach Anspruch 2, 3 oder 4, wobei die zweite Einrichtung des Emitterfolgers (121) einen Transistor (104), dessen Emitter mit dem Eingang des Operationsverstärkers (119), dessen Kollektor mit der Stromversorgung (123) und dessen Basis mit der zweiten Seite des Ausgangs des Differenzverstärkers (120) verbunden ist, sowie eine Konstantstromquelle zum Liefern eines konstanten Basisstroms für den Transistor (104) aufweist.

6. Mehrstufiger Differenzverstärker nach einem der Ansprüche 1 bis 5, wobei in dem Operationsverstärker (119) ein invertierender Eingangsanschluß mit einer externen Steuer-Stromversorgung (116), ein nicht invertierender Eingangsanschluß mit der Emitterseite eines jeden der Transistoren (103, 104) des Emitterfolgers (121) über die Widerstände (109, 110) des Emitterfolgers und ein Ausgangsanschluß mit einem Eingang der regelbaren Stromquelle (122) verbunden ist.

7. Mehrstufiger Differenzverstärker nach einem der Ansprüche 1 bis 6, wobei die regelbare Stromquelle (122) eine mit dem Ausgang des Operationsverstärkers (119) und mit der ersten Seite des Ausgangs des Differenzverstärkers (120) verbundene erste Einrichtung zum Steuern der Spannung der ersten Seite des Ausgangs des Differenzverstärkers (120) in Abhängigkeit von dem Ausgangssignal des Operationsverstärkers (119) sowie eine mit dem Ausgang des Operationsverstärkers (119) und mit der zweiten Seite des Ausgangs des Differenzverstärkers (120) verbundene zweite Einrichtung zum Steuern der Spannung der zweiten Seite des Ausgangs des Differenzverstärkers (120) in Abhängigkeit von dem Ausgangssignal des Operationsverstärkers (119) aufweist.

8. Mehrstufiger Differenzverstärker nach Anspruch 7, wobei die erste Einrichtung der regelbaren Stromquelle (122) einen Transistor (106) aufweist, dessen Emitter über einen Widerstand (112) mit Masse, dessen Kollektor mit der ersten Seite des Ausgangs des Differenzverstärkers (120) und dessen Basis mit dem Ausgang des Operationsverstärkers (119) verbunden ist.

9. Mehrstufiger Differenzverstärker nach Anspruch 7 oder 8, wobei die zweite Einrichtung der regelbaren Stromquelle (122) einen Transistor (105) aufweist, dessen Emitter über einen Widerstand (111), dessen Kollektor mit der zweiten Seite des Ausgangs des Differenzverstärkers (120) und dessen Basis mit dem Ausgang des Operationsverstärkers (119) verbunden ist.

## Revendications

1. Amplificateur différentiel composé, comprenant une source d'alimentation (123) pour alimenter le circuit, un amplificateur différentiel (120) pour amplifier un signal de tension rentré depuis une source de signal d'entrée, un émetteur-suiveur (121) connecté à la sortie de l'amplificateur différentiel (120) pour amplifier le signal de tension, un amplificateur opérationnel (119) connecté à la sortie de l'émetteur-suiveur (121) et à une source de tension de référence (116) pour amplifier la tension continue (DC) délivrée par l'émetteur-suiveur, et une source de courant variable (122) ayant une entrée de commande connectée à la sortie de l'amplificateur opérationnel (119) et une sortie connectée à l'entrée de l'émetteur-suiveur (121) pour commander la tension à l'entrée de l'émetteur-suiveur (121) en réponse à la sortie de l'amplificateur opérationnel de telle sorte que la composante continue de la sortie provenant de l'émetteur-suiveur tend vers la tension de référence provenant de la source de tension de référence, de sorte que la composante continue de la sortie de l'amplificateur opérationnel s'approche de la tension de référence.

2. Amplificateur différentiel composé selon la revendication 1, dans lequel l'émetteur-suiveur (121) comprend des premiers moyens connectés à un premier côté de la sortie de l'amplificateur différentiel (120) pour amplifier le signal de tension provenant du premier côté, et des deuxièmes moyens connectés à un deuxième côté de la sortie de l'amplificateur différentiel (120) pour amplifier le signal de tension provenant du deuxième côté.

3. Amplificateur différentiel composé selon la revendication 2, dans lequel l'émetteur-suiveur (121) comprend en outre une pluralité de résistances (109, 110) pour fournir à l'amplificateur différentiel (119) une tension de point milieu entre la tension continue délivrée par les premiers moyens de l'émetteur-suiveur et la tension continue délivrée par les deuxièmes moyens de l'émetteur-suiveur.

4. Amplificateur différentiel composé selon la revendication 2 ou 3, dans lequel les premiers moyens de l'émetteur-suiveur (121) comprennent un transistor (103) dont l'émetteur est connecté à l'entrée de l'amplificateur opérationnel, le collecteur est connecté à la source d'alimentation (123) et la base est connectée au premier côté de la sortie de l'amplificateur différentiel (120), et une source de courant constant pour fournir un courant de base constant du transistor (103).

5. Amplificateur différentiel composé selon la revendication 2, 3 ou 4, dans lequel les deuxièmes moyens de l'émetteur-suiveur (121) comprennent un transistor (104) dont l'émetteur est connecté à l'entrée de l'amplificateur opérationnel (119), le collecteur est connecté à la source d'alimentation (123) et la base est connectée au second côté de la sortie de l'amplificateur différentiel (120), et une source de courant constant pour fournir un courant de base constant du transistor (104).

6. Amplificateur différentiel composé selon l'une quelconque des revendications 1 à 5, dans lequel dans l'amplificateur opérationnel (119), une borne d'entrée inversive est connectée à une source d'alimentation de commande extérieure (116), une borne d'entrée non inversive est connectée au côté de l'émetteur de chacun des transistors (103, 104) de l'émetteur-suiveur (121) par les résistances (109, 110) de l'émetteur-suiveur, et une borne de sortie est connectée à une entrée de la source de courant variable (122).

7. Amplificateur différentiel composé selon l'une quelconque des revendications 1 à 6, dans lequel la source de courant variable (122) comprend des premiers moyens connectés à la sortie de l'amplificateur opérationnel (119) et connectés au premier côté de la sortie de l'amplificateur différentiel (120) pour commander la tension du premier côté de la sortie de l'amplificateur différentiel (120) en réponse à la sortie de l'amplificateur opérationnel (119), et des deuxièmes moyens connectés à la sortie de l'amplificateur opérationnel (119) et connectés au deuxième côté de la sortie de l'amplificateur différentiel (120) pour commander la tension du deuxième côté de la sortie de l'amplificateur différentiel (120) en réponse à la sortie de l'amplificateur opérationnel (119).

8. Amplificateur différentiel composé selon la revendication 7, dans lequel les premiers moyens de la source de courant variable (122) comprennent un transistor (106) dont l'émetteur est connecté à la masse par une résistance (112), le collecteur est connecté au premier côté de la sortie de l'amplificateur différentiel (120), et la base est connectée à la sortie de l'amplificateur opérationnel (119).

9. Amplificateur différentiel composé selon la revendication 7 ou 8, dans lequel les deuxièmes moyens de la source de courant variable (122) comprennent un transistor (105) dont l'émetteur est connecté à la masse par une résistance (111), le collecteur est connecté au second côté de la sortie de l'amplificateur différentiel (120), et la base est connectée à la sortie de l'amplificateur opérationnel (119).
